# EUROPÄISCHE PATENTANMELDUNG

(11) **EP 1 030 360 A2**
(43) Veröffentlichungstag der Anmeldung: **23.08.2000**
(21) Anmeldenummer: 00101693.0
(22) Anmeldetag: 03.02.2000
(51) Int. Cl.: H01L 21/66

(54) **Elektrische Teststruktur auf einem Halbleitersubstrat und Testverfahren**

(30) Priorität: 15.02.1999 DE 19906292
(71) Anmelder: Infineon Technologies AG, 81541 München (DE)
(72) Erfinder: Lichter, Gerd, 01471 Radeburg (DE)
(74) Vertreter: Zedlitz, Peter, Dipl.-Ing.

(57) **Zusammenfassung**

Die Teststruktur weist eine Transistorreihe von mindestens zwei Transistoren auf, wobei die S/D-Gebiete der Transistoren in Reihe geschaltet sind und das erste und das letzte S/D-Gebiet der Reihe anschließbar sind. Ein eventuelle Anätzung des Gate-Polysiliziums kann durch Messen des Widerstandes zwischen den Anschlüssen (22, 23) bei geeignetem Gatepotential festgestellt werden. Die Erfindung ermöglicht insbesondere eine in-situ-Kontrolle eines KOH-Angriffs auf das n-dotierte Gate-Polysilizium in einer DRAM-Speicherzelle.

## Beschreibung

Die Erfindung betrifft eine elektrische Teststruktur in einer integrierten Schaltung, insbesondere in einer DRAM-Schaltung mit Grabenkondensatoren, sowie ein Testverfahren.

Für die Herstellung einer integrierten Schaltung auf einem Halbleitersubstrat sind eine Vielzahl von Prozeßschritten notwendig. Eine Anzahl von Prozeßschritten, die der Erzeugung einer bestimmten (Teil-) Struktur der Schaltung dienen, wird als Modul bezeichnet; Beispiel hierfür sind Module zur Bildung von Isolationsgräben im Substrat, zur Bildung eines Transistors oder zur Bildung eines Kondensators. Zur Identifikation von Fehlerquellen ist es notwendig, einzelne Prozeßschritte oder komplette Module in geeigneter Weise zu überprüfen, ob vorgegebene Spezifikationen eingehalten werden. Dabei können sog. 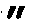 Monitorscheiben" (zusätzliche Wafer, auf denen nicht die komplette Schaltung hergestellt wird), oder die Wafer mit den teilweise fertiggestellten Schaltungen selbst verwendet werden. Unter anderen können optische oder elektrische Testverfahren eingesetzt werden, wobei die Schaltung selbst oder eigene Teststrukturen ausgewertet werden.

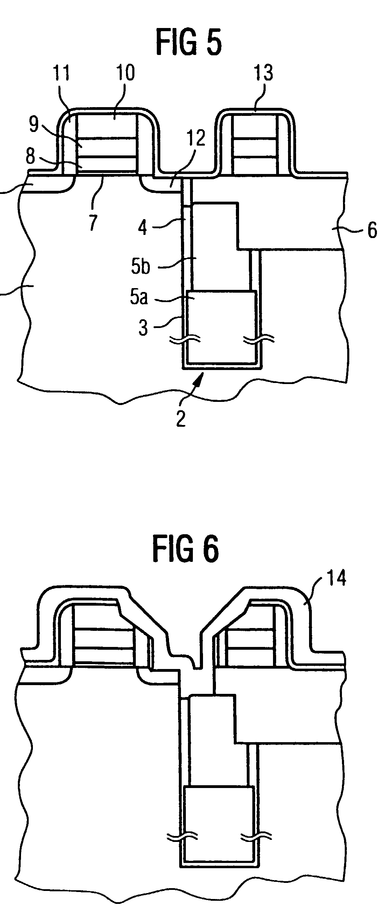

Die vorliegende Erfindung betrifft ein Testverfahren und eine Teststruktur, die insbesondere bei der Herstellung von DRAM-Speichern mit Grabenkondensatoren und einem Polysilizium-Streifen (Surface-Strap) als elektrische Verbindung zwischen Auswahltransistor und Kondensator einsetzbar sind und an diesem Beispiel näher erläutert werden. Die wesentlichen Schritte des Hersteilverfahrens bzw. des hier relevanten Prozeßmoduls für den genannten Speicherzellentyp sind in den Figuren 5 bis 8 dargestellt. Es ist vorgesehen (siehe Figur 5), in einem Halbleitersubstrat 1 einen Graben 2 für einen Kondensator zu bilden, dessen Wand im unteren Abschnitt mit einem Kondensatordielektrikum 3 und im oberen Abschnitt mit einem dickeren Isolationskragen 4 versehen ist und der mit dotiertem Polysilizium 5a, 5b als Speicherelektrode aufgefüllt ist. Ein Isolationsgraben 6 wird gebildet, der den Graben teilweise überlappt und beispielsweise mit TEOS gefüllt ist. Der Isolationsgraben dient insbesondere der Isolation zu einer benachbarten Speicherzelle, die sich spiegelbildlich an die in Figur 5 dargestellte an der rechten Seite anschließt. Benachbart zum Kondensatorgraben 2 wird dann der Auswahltransistor gebildet. Auf einem Gateoxid 7 wird ein sog. Gate-Stack bestehend aus insbesondere n-dotiertem Polysilizium 8, einer darauf angeordneten weiteren leitenden Schicht 9 (beispielsweise WSi oder ein anderes Silizid) und einer Deck-Isolationsschicht 10 (beispielsweise aus Siliziumoxid oder- nitrid). An den Seitenwänden des Gate-Stack wird ein isolierender Spacer 11 vorzugsweise aus dem Material der Deck-Isolationsschicht erzeugt und die S/D-Gebiete 12 des Transistors werden implantiert. Ggf. kann der Spacer zweiteilig ausgebildet sein, wobei nach dem ersten Teilspacer in bekannter Weise LDD-Gebiete implantiert werden. Damit ist der Auswahltransistor der Speicherzelle fertiggestellt. Nachfolgend wird eine Siliziumnitridschicht 13 aufgebracht. Vorzugsweise liegt ihre Dicke im Bereich 20 bis 30nm.

Das weitere Verfahren sieht vor (siehe Figur 6), mit Hilfe einer Photomaske die Nitridschicht 13 an den Stellen wieder zu entfernen, an denen die 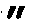 Surface-Straps" zur elektrischen Verbindung zwischen Auswahltransistor und Kondensator gebildet werden sollen. Gleichzeitig wird in den oberen Bereich des Grabenkondensators hineingeätzt und hier insbesondere der dicke Isolationskragen bis zu einer vorgegebenen Tiefe entfernt, so daß auch hier der Kontakt zum Kondensator ermöglicht wird. Die Photomaske besitzt also eine Öffnung über einem Bereich der Kondensatorauffüllung und dem benachbarten S/D-Gebiet. Der eingesetzte Ätzprozeß (beispielsweise unter Verwendung von CHF₃/CF₄ sowie Sauerstoff und Argon) greift auch die Deck-Isolationsschicht 10 und den Seitenwandspacer 11 des Gate-Stack an, so daß die Gefahr besteht, das dotierte Polysilizium 8 der Wortleitung freizulegen. Nach Entfernung der Photomaske wird eine Implantation insbesondere mit BF₂-Ionen durchgeführt, daß verbliebene Nitrid 13 wirkt dabei als Dotiermaske. Die Öffnung in der Nitridschicht 13 entspricht der Öffnung der Photomaske. Im wesentlichen wird freiliegendes Silizium p-dotiert - also der Bereich der Kondensatorauffüllung und das benachbarte S/D-Gebiet - , während in freiliegendem Siliziumoxid kaum B⁺-Ionen deponiert werden. Anschließend wird undotiertes Polysilizium 14 aufgebracht und mittels Ausdiffusion aus dem unterliegenden dotierten Silizium und Polysilizium abschnittsweise p-dotiert. Das Polysilizium 14 füllt das im Graben entstandene Loch dabei auf, seine Dicke beträgt vorzugsweise 50 bis 100nm.

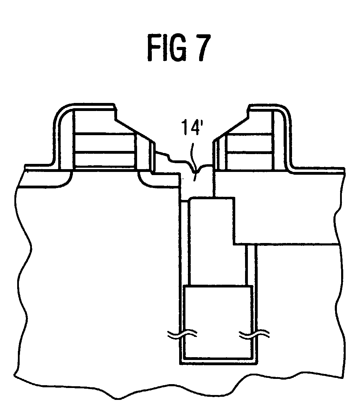

Mit einer KOH-Ätzung oder einer anderen geeigneten selektiven Ätzung, die die so erzeugten p⁺-dotierten Polysilizium-Abschnitte 14' nicht angreift, wird das undotierte Polysilizium 14 entfernt (siehe Figur 7). Die dotierten p⁺-Polysilizium-Abschnitte 14' bilden die 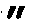 Surface-Straps". Es besteht jedoch die Gefahr, daß eventuell freigelegtes n-dotiertes Polysilizium 8 des Gates ebenfalls angegriffen und entfernt wird. Auch p⁻-dotiertes Silizium als Gatebestandteil würde durch das Ätzmittel angegriffen. Dies führt zum Ausfall des Auswahltransistors (und damit der Speicherzelle), da dann ein Hohlraum über dem Gateoxid entsteht und der Transistor nicht schaltbar ist. Es hat sich gezeigt, daß die ausfallenden Zellen meist statistisch verteilt sind und Korrelationen nicht nur zu einem, sondern zu mehreren vorangehenden Prozeßschritten bestehen.

Der beschriebene Ausfallmechanismus führt zu einem Ausbeuteeinbruch. Eine elektrisch Inline-Kontrolle während des Fertigungsprozesses ist bisher nicht möglich, insbesondere, da das Problem in der Regel nur im Zellenfeld auftritt. Ebenso wenig ist eine eindeutige Zuordnung des KOH-Angriffs zu (späteren) Testdaten möglich.

Weitere Einzelheiten des hier nur in den wesentlichen Punkten beschriebenen Verfahrens sind beispielsweise in EP 543 158 A2 und EP 651 433 A1 (insbesondere Spalte 4 und 6 der Beschreibung) offenbart.

Aufgabe der vorliegenden Erfindung ist daher, ein Testverfahren und ein Teststruktur anzugeben, die eine Inline-Kontrolle, d.h. eine prozessbegleitende Kontrolle ermöglichen. Diese Aufgabe wird durch die Merkmale der Patentansprüche 1 und 5 gelöst.

Die Teststruktur weist mindestens zwei Transistoren mit in Serie geschalteten S/D-Gebieten auf, die in gleicher Weise wie der Auswahltransistor hergestellt werden. Sie weisen also einen Gate-Stack mit n-dotiertem oder p⁻dotiertem Polysilizium und mindestens einen isolierenden Seitenwand-Spacer auf. Das erste und das letzte S/D-Gebiet der Transistorreihe ist von außen über einen ersten bzw. zweiten Anschluß anschließbar. Die Gates sind ebenfalls anschließbar. Das Testverfahren sieht vor, diese Teststruktur entsprechend dem eingangs erläuterten Modul zur Erzeugung des Surface-Strip weiter zu prozessieren. Es wird also die erläuterte Nitridschicht aufgebracht und mit der Photomaske strukturiert. Die Öffnungen der Photomaske erstrecken sich im Bereich der Teststruktur mindestens über die Gebiete der Transistoren, bei denen auch im Zellenfeld bei den entsprechenden Transistoren Öffnungen vorhanden sind. Vorzugsweise sind die Öffnungen in Bereich der Teststruktur jedoch größer, so daß quasi 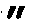 Worst-Case"-Bedingungen für den Transistor, nämlich ein ausgedehnterer Ätzangriff, geschaffen werden. Das Verfahren wird wie eingangs beschrieben fortgesetzt und ein Surface-Strap gebildet. Dann wird an die Gates der 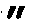 normally off"- Transistoren ein Potential angelegt, das einem geöffneten Zustand der Transistoren entspricht. Der zwischen dem ersten und zweiten Anschluß der Teststruktur fließende Strom wird gemessen. Wenn bei einem Gate-Potential, das einem geöffneten Zustand der Transistoren entspricht, durch die Transistorreihe kein Strom fließt bzw. der Widerstand stark ansteigt, mit anderen Worten wenn mindestens ein Transistor der Reihe nicht schaltbar ist, läßt dies einen Rückschluß auf einem KOH-Angriff zu. Bei einem Widerstandswert innerhalb der Spezifikation ist ein KOH-Angriff ausgeschlossen. Der typische Wert für einen 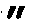 off-Strom" eines Transistors (beispielsweise in einer Speicherzelle) beträgt 10⁻⁶-10⁻⁵ pA. Der 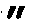 On-Strom" liegt im bereich 10-100µA. Bei einem KOH-Angriff ist der Strom bei 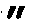 On-Bedingungen" daher um mehrere Größenordnungen geringer als bei fehlerfreiem Prozess.

Durch Einsatz der Teststruktur und des Testverfahrens können mögliche Ausbeuteeinbrüche prozeßbegleitend erkannt werden, wodurch sich ein beträchtlicher Zeitgewinn ergibt. Es können Korrelationen zu Prozeßparametern festgestellt werden und ggf. Fehlerquellen eliminiert werden.

Die Teststruktur benötigt nur wenig Platz. Beispielsweise können die aktiven Gebiete der Transistoren linear angeordnet sein, d.h. einen durchgehenden Streifen kristallinen Silizium darstellen, der in vorgegebenen Bereichen zur Bildung der S/D-Gebiete dotiert ist und eventuell zusätzlich siliziert (mit TiSi oder ähnliches) sein kann. Die Gates der Transistoren verlaufen jeweils quer zu diesen Streifen, vorzugsweise wird eine durchgehende Wortleitung mäanderförmig (im weitesten Sinne zick-zack-förmig) über das aktive Gebiet gelegt, die das aktive entsprechend der Anzahl der zu bildenden Transistoren kreuzt. Das kristalline Silizium wird von einem Isolationsgebiet (beispielsweise Shallow Trench Isolation) umgeben. Der kristalline Siliziumstreifen ist an einem Ende mit dem ersten Anschluß und an anderen Ende mit dem zweiten Anschluß versehen.

Die bevorzugte Angabe von Transistoren in der Reihe ist abhängig von den gegebenen Randbedingungen, insbesondere dem zur Verfügung stehenden Platz. Sinnvoll sind beispielsweise 4-5 Transistoren, um ein zuverlässiges Testergebnis zu erhalten. Auch mehr Transistoren sind denkbar.

Die Erfindung wird im folgenden anhand eines Ausführungsbeispiels und der Figuren näher erläutert. Es zeigen:
- Figur 1: eine Aufsicht auf eine Teststruktur
- Figuren 2-4: einen Querschnitt durch zwei benachbarte Transistoren der Teststruktur, an den das Testverfahren erläutert wird,
- Figuren 5-7: einen Querschnitt durch eine DRAM-Speicherzelle, an dem das zu untersuchende Prozeßmodul erläutert wird.

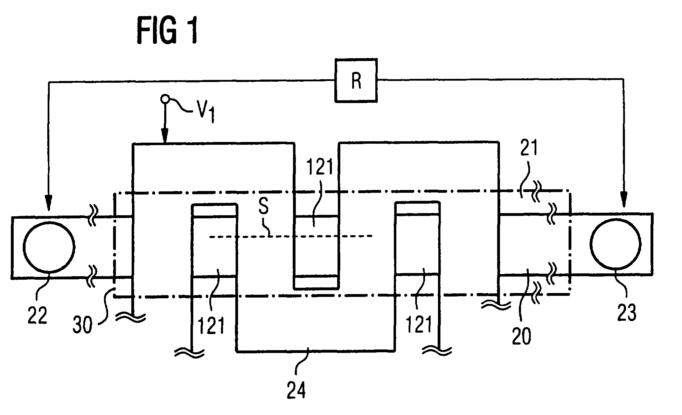

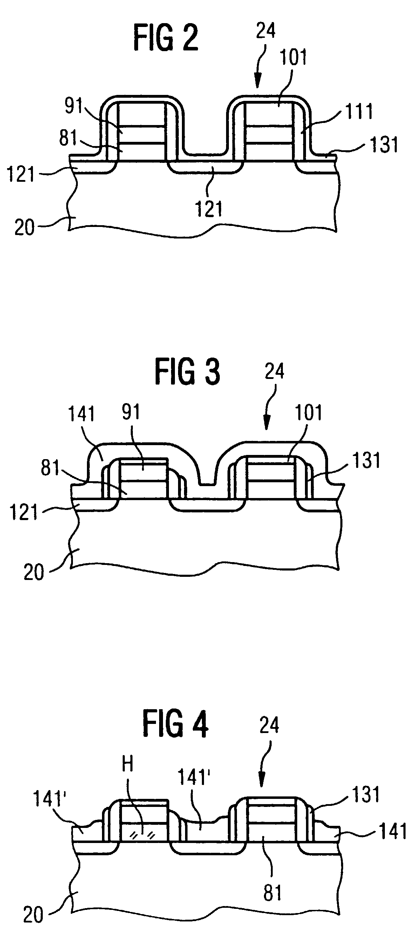

Figur 1: Eine einfache und platzsparende Struktur wird durch einen Streifen kristallinen Siliziums 20 als aktives Gebiet der Transistoren und eine mäandrierend darüber verlaufende Wortleitung 24 gebildet. Der Verlauf der Wortleitung 24 entspricht eine Rechteckfunktion. Die Aufsicht zeigt ein streifenförmiges kristallines Siliziumgebiet 20 als aktives Gebiet, das von einem Isolationsgebiet 21 an der Substratoberfläche umgebend ist. Das Siliziumgebiet 20 weist einen ersten Anschluß 22 und einen zweiten Anschluß 23 auf. Zwischen diesen Anschlüssen wird das Siliziumgebiet von einer durchgehenden Wortleitung 24 mehrfach überkreuzt. Dabei stellt jeder der Kreuzungspunkte zwischen der Wortleitung und dem aktiven Gebiet ein Gate mit unterliegendem Kanalgebiet eines Transistors dar. Wie in den Figuren 2 bis 4 dargestellt, ist diese Wortleitung als Gate-Stack aufgebaut und mit einer isolierenden Abdeckung und isolierenden Spacern versehen, dann werden durch Implantation die S/D-Gebiete 121 im Siliziumstreifen 20 hergestellt. Auf diese Weise sind die in Reihe geschalteten Transistoren der Teststruktur gebildet.

Figur 2 zeigt einen Schnitt durch einen Ausschnitt der Teststruktur entlang der gepunkteten Linie S in Figur 1. Die Transistoren werden in gleicher Weise und gleichzeitig mit den Auswahltransistoren im Zellenfeld hergestellt, die Wortleitung besteht also aus n-dotiertem Polysilizium 81, einem Silizid 91 (insbesondere WSi) der isolierenden Gate-Abdeckung 101 und seitlichen isolierenden Spacern 111. Das Gateoxid unterhalb des n-dotierten Silizium wurde hier nicht dargestellt. Die Implantation der S/D-Gebiete 121 erfolgt gleichzeitig mit der Implantation der Auswahltransistoren. Die so erzeugte Teststruktur wird dem erläuterten Prozeßmodul unterworfen. Es wird also eine Nitridschicht 131 ganzflächig abgeschieden und eine Photomaske aufgebracht. Die Photomaske besitzt eine Öffnung innerhalb des in Figur 1 gezeigten, strichpunktierten Bereichs 30. Die Schnittlinie S liegt vollständig innerhalb dieses Bereichs 30, so daß die Maske hier entfernt wird und in Figur 2 nicht erkennbar ist. Wie bereits erläutert, kann die Öffnung 30 auch kleiner sein, es muß nur bei jedem Transistor der Teststruktur mindestens das entsprechende Gebiet wie bei einem Transistor im Zellenfeld freiliegen, also mindestens eine Kante des Gates und einen Teil des S/D-Gebietes überlappen. Durch die in diesen Ausführungsbeispiel sehr viel größere Öffnung 30 wird ein möglicher KOH-Angriff sicher detektiert. Ferner erstreckt sich die Maskenöffnung 30 durchgehend über alle Transistoren, wie in der Figur 1 dargestellt.

Figur 3: es wird der erläuterte Ätzprozeß zur Entfernung der Nitridschicht 131 - und zur seitlichen Freilegung des S/D-Gebietes in Zellenfeld - durchgeführt. Das Siliziumsubstrat wird dabei nicht angegriffen. In der Teststruktur wird dabei die Gateabdeckung gedünnt. Die erläuterte p-Implantation wird durchgeführt und eine undotierte Polysiliziumschicht 141 wird aufgebracht. Der Temperaturschritt zur Ausdiffusion wird durchgeführt, so daß die undotierte Polysiliziumschicht 141 abschnittsweise p-dotiert wird und Abschnitte 141' gebildet werden. Innerhalb des dargestellten Ausschnitts in Figur 2 bis 4 wird die als Diffusionssperre dienende Nitridschicht bis auf eventuelle (durch die Anisotrope des Ätzprozesses verursachte) Spacer entfernt. Die darauffolgende Implantation deponiert den p-Dotierstoff aber nicht gleichmäßig über die gesamte Oberfläche, sondern in Abhängigkeit von unterliegenden Material. Daher wird bei der Ausdiffusion nicht eine durchgehende p-dotierte Polysiliziumschicht 141' gebildet.

Figur 4: mittels einer KOH-haltigen Ätzlösung wird das undotierte Polysilizium 141 selektiv zu den durch Ausdiffusion dotierten Abschnitten 141' entfernt. Ist durch vorherige Prozesse das n-Polysilizium 81 des nicht mehr ausreichend isoliert, kann es herausgelöst werden, wie im linken Transistor in der Figur 4 angedeutet. Hier ist ein Hohlraum H gebildet. Dieser Transistor ist nicht mehr über das Gatepotential schaltbar.

Anschließend wird ein elektrisches Testverfahren durchgeführt. An die Wortleitung 24 wird ein Potential 1 angelegt, das einem leitenden Zustand der Transistoren entspricht, und der zwischen dem ersten Anschluß 22 und dem zweiten Anschluß 23 vorliegende Widerstand wird ermittelt. Wenn dieser Widerstand den Spezifikationen der Transistorreihe entspricht, ist ein KOH-Angrift in der Teststruktur ausgeschlossen. Da die Teststruktur 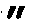 worst case" Bedingungen ausgesetzt war, kann im Zellenfeld ein KOH-Angriff mit großer Sicherheit ausgeschlossen werden.

Ersichtlich können das Prinzip des Testverfahrens und die Teststruktur auch eingesetzt werden um ganz allgemein eine gewollte oder nicht gewolllte Unterätzung (Entfernung des Polysiliziums) zu detektieren. Bei 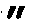 normally-off"-Transistoren bewirkt eine Unterätzung bei mindestens einem der Transistoren dann einen weiterhin hohen Widerstand bei Anlagen eines Potentials (das 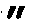 On" entspricht) an die Gates. Bei 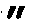 normally-on"-Transistoren bewirkt eine Unterätzung bei allen Transistoren einen weiterhin niedrigen Widerstand auch bei Anlegen eines 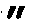 Off"-Potentials an die Gates. Bei dieser allgemeinen Anwendung der Erfindung sind die auf die Speicherzellen-Herstellung abgestimmten Schritte (insbesondere die Nitridschicht, die undotierte Polysiliziumschicht, Ausdiffusion bzw. Implantation) nicht erforderlich. Ist die Erzeugung des Hohlraums H gewünscht, wird mittel des Ätzprozesses duch die Öffnung (30) der Photomaske ein geeigneter Zugang zur unteren Polysiliziumschicht erzeugt.

## Patentansprüche

1. Halbleiterstruktur mit mindestens zwei MOS-Transistoren in einem Halbleitersubstrat,
- bei der jeder Transistor ein Gate mit einer n-dotierten oder p⁻-dotierten Polysiliziumschicht (81) und einer dar-über angeordneten leitenden Schicht (91) aufweist, wobei das Gate mit einer Deck-Isolationsschicht (101) und isolierenden Seitenwand-Spacern (111) versehen ist, sowie ein erstes und ein zweites S/D-Gebiet (121),
- bei der die Gates miteinander elektrisch verbunden sind und einen Anschluß aufweisen,
- bei der das zweite S/D-Gebiet des ersten Transistors mit dem ersten S/D-Gebiet des zweiten Transistors elektrisch verbunden ist,
- bei der das erste S/D-Gebiet des ersten Transistors mit einem ersten Anschluß (22) und das zweite S/D-Gebiet des zweiten Transistors mit einem zweiten Anschluß (23) verbunden ist.

2. Halbleiterstruktur nach Anspruch 1, bei der die aktiven Gebiete der Transistoren einen zusammenhängenden Streifen monokristallinen Siliziums (20) im Halbleitersubstrat (1) bilden, und der erste Anschluß (22)und der zweite Anschluß (23) randnah an entgegengesetzten Enden des Streifens angeordnet sind.

3. Halbleiterstruktur nach Anspruch 2, mit einer mäandrierend über den Siliziumstreiten (20) verlaufenden, durchgehenden Wortleitung (25) für die Transistoren, die die Gates enthält.

4. Halbleiterstruktur nach einem der Ansprüche 1 bis 3, bei der die leitende Schicht (91) aus einem Silizid, insbesondere aus WSi, besteht.

5. Verfahren zum Detektieren eines Ätzangriffs auf eine Polysilizium-Leitbahn unter Verwendung eines elektrischen Testverfahrens, mit folgenden Schritten:
- Bilden einer Halbleiterstruktur nach einem der Ansprüche 1 bis 4 als Teststruktur,
- Aufbringen einer Photomaske mit einer Öffnung (30) die mindestens jeweils einen isolierenden Spacer (111) an einer Seite jedes Transistors freilegt, und Durchführen eines Ätzprozesses durch diese Öffnung, und Entfernen der Photomaske,
- Durchführen einer selektiven Naßätzung, die Polysilizium angreift,
- Anlegen eines Potentials an die Gates der Transistoren,
- Messen des Widerstands zwischen dem ersten Anschluß (22) und dem zweiten Anschluß (23).

6. Verfahren zum Detektieren eines Ätzangriffs auf eine Polysilizium-Leitbahn unter Verwendung eines elektrischen Testverfahrens, mit folgenden Schritten:
- Bilden einer Halbleiterstruktur nach einem der Ansprüche 1 bis 4 als Teststruktur,
- Aufbringen einer Nitridschicht (131)
- Aufbringen einer Photomaske mit einer Öffnung (30), die mindestens jeweils einen isolierenden Spacer (111) an einer Seite jedes Transistors freilegt, und Ätzen der Nitridschicht (131) durch diese Öffnung, und Entfernen der Photomaske,
- Implantation mit einem p-Dotierstoff,
- Aufbringen einer undotierten Polysiliziumschicht (141) und abschnittsweise Dotierung dieser Schicht durch Ausdiffusion aus der Unterlage,
- Entfernen der undotierten Abschnitte der Polysiliziumschicht (141) mit Hilfe einer selektiven Naßätzung
- Anlegen eines dem leitenden Zustand der Transistoren entsprechenden Potentials (V₁) an die Gates der Transistoren,
- Messen des Widerstands zwischen dem ersten Anschluß (22) und dem zweiten Anschluß (23).

7. Verfahren nach Anspruch 6, bei dem gleichzeitig mit den Transistoren der Teststruktur ein Auswahltransistor einer Speicherzelle in einer DRAM-Schaltung hergestellt wird.

8. Verfahren nach einem der Ansprüche 6 bis 7, bei dem gleichzeitig mit der Bildung der p-dotierten Polysiliziumabschnitte (141') ein p-dotierter Polysilizium-Anschlußstreifen (14') zur elektrischen Verbindung des Auswahltransistors mit einer Elektrode eines Speicherkondensators der Speicherzelle gebildet wird.
